# FASCICULE DE BREVET EUROPEEN

(11) **EP 4 271 165 B1**
(45) Date de publication et mention de la délivrance du brevet: **25.12.2024**
(21) Numéro de dépôt: 23169776.4
(22) Date de dépôt: 25.04.2023
(51) Int. Cl.: H10N 60/01, H10N 60/10, H10N 60/12, H10N 69/00, G06N 10/40

(54) **PROCEDE DE REALISATION D'UN DISPOSITIF ELECTRONIQUE A QUBIT(S) SUPRACONDUCTEUR(S) INCLUANT AU MOINS UN JOFET**
VERFAHREN ZUR HERSTELLUNG EINER SUPRALEITENDEN ELEKTRONISCHEN VORRICHTUNG MIT MINDESTENS EINEM JOFET
METHOD FOR MAKING AN ELECTRONIC DEVICE WITH SUPERCONDUCTING QUBIT(S) INCLUDING AT LEAST ONE JOFET

(30) Priorité: 26.04.2022 FR 2203899
(43) Date de publication de la demande: 01.11.2023
(73) Titulaire: Commissariat à l'Energie Atomique et aux Energies Alternatives, 75015 Paris (FR)
(72) Inventeur: LE ROYER, Cyrille, 38054 GRENOBLE CEDEX 09 (FR); NEMOUCHI, Fabrice, 38054 GRENOBLE CEDEX 09 (FR); POSSEME, Nicolas, 38054 GRENOBLE CEDEX 09 (FR); KERDILES, Sébastien, 38054 GRENOBLE CEDEX 09 (FR); LEFLOCH, François, 38054 GRENOBLE CEDEX 09 (FR)
(74) Mandataire: Brevalex

(56) Documents cités:
- FR-A1- 3 088 483
- US-A1- 2021 226 114
- US-A1- 2021 296 557
- US-A1- 2021 384 405
- LUCAS CASPARIS ET AL: "Superconducting Gatemon Qubit based on a Proximitized Two-Dimensional Electron Gas", ARXIV.ORG, CORNELL UNIVERSITY LIBRARY, 201 OLIN LIBRARY CORNELL UNIVERSITY ITHACA, NY 14853, 21 November 2017 (2017-11-21), XP081148608, DOI: 10.1038/S41565-018-0207-Y
- DAUBRIAC R ET AL: "Superconducting Polycrystalline Silicon Layer Obtained by Boron Implantation and Nanosecond Laser Annealing", vol. 10, no. 1, 25 January 2021 (2021-01-25), US, pages 14004, XP093006638, ISSN: 2162-8769, Retrieved from the Internet <URL:https://iopscience.iop.org/article/10.1149/2162-8777/abdc41/pdf> DOI: 10.1149/2162-8777/abdc41

## Description

### DOMAINE TECHNIQUE

L'invention concerne le domaine des dispositifs électroniques à un ou plusieurs qubits supraconducteurs, et plus particulièrement à qubit(s) de type gatemon. L'invention s'applique avantageusement à la réalisation, dans une couche de semi-conducteur, d'un tel dispositif.

### ÉTAT DE LA TECHNIQUE ANTERIEURE

Dans un qubit supraconducteur, le qubit prend la forme de l'état d'un courant supraconducteur qui traverse une barrière très fine en s'appuyant sur l'effet Josephson. Il existe plusieurs types de qubits supraconducteurs : qubits de flux, de phase, ou de charge. Dans ces différents types de qubits, il s'agit de créer une superposition de deux états distincts d'un courant oscillant à haute fréquence et traversant la jonction Josephson dans une boucle supraconductrice. L'oscillation est rendue possible par le fait que la boucle intègre l'équivalent d'une inductance et d'une résistance. L'oscillation du courant est activée par l'application de micro-ondes de fréquences situées entre 5 et 10 GHz et transmises par voie conductrice et physique. L'état du qubit correspond à la phase de résonance du courant ou au sens du courant, mesuré par un magnétomètre ou par couplage à un résonateur micro-onde.

Dans un qubit de type gatemon, la jonction Josephson peut être réalisée par un transistor à effet de champ à jonction Josephson, également appelé JoFET pour « Josephson Field Effect Transistor » ou JJ-FET pour « Josephson Junction Field Effect Transistor ». Un tel transistor comporte une grille disposée au-dessus d'une région semi-conductrice de canal s'étendant entre des régions de source et de drain supraconductrices.

Un inconvénient lié à la réalisation de ce type de qubit est que les régions supraconductrices sont généralement réalisées à partir de matériaux non compatibles avec les technologies semi-conducteurs classiquement utilisées en microélectronique.

Le document US 2021 / 296557 A1 divulgue un procédé d'implantation masquée similaire à la présente demande pour produire un qubit supraconductrice dans lequel la supraconductivité est obtenue par implantation d'un semi-conducteur. Néanmoins, les étapes consécutives de la revendication 1 ne sont pas divulguées par US 2021 / 296557 A1. Notamment, ces étapes de la revendication 1 visent à la production d'une grille afin d'obtenir un qubit du type gatemon.

De manière similaire, la structure obtenue par le procédé de US 2021/226114 A1 ne comporte pas une grille et, conséquemment, le document US 2021/226114 A1 ne divulgue pas des étapes correspondantes pour produire une grille. D'ailleurs, dans la structure de US 2021/226114 A1, les deux électrodes supraconductrices sont arrangées l'une sur l'autre. Donc, dans la structure de US 2021/226114 A1, il n y a pas une première région couverte par une potion diélectrique de protection disposée entre deux régions implantées par des dopants telle que définie par la revendication 1.

Le procédé de US 2021/384405 A1 comporte une région dopée 204 disposée entre deux régions non-dopées. D'ailleurs, il n y a pas de divulgation d'un dépôt consécutif d'une couche diélectrique de protection ou des étapes suivantes définies par la revendication 1.

L'article Casparis et al.: "Superconducting Gatemon Qubit based on a Proximitized Two-Dimensional Electron Gas", XP081148608, DOI: 10.1038/S41565-018-0207-Y propose une structure d'un qubit du type gatemon et un procédé pour le produire. Néanmoins, les zones supraconductrices de la structure telle que visible dans Casparis et al. sont en aluminium. Il n y a donc pas des étapes d'implantation des zones d'un semi-conducteur en zones arrangées de manière définie par la revendication 1.

L'article Daubriac et al.: "Superconducting Polycrystalline Silicon Layer Obtained by Boron Implantation and Nanosecond Laser Annealing", ECS Journal of Solid State Science and Technology, vol. 10, no. 1, page 14004, XP093006638, DOI: 10.1149/2162-8777/abdc41 décrit l'obtention d'une zone supraconductrice dans un semi-conducteur par dopage, mais il n y a aucune divulgation des étapes de la revendication 1.

Le document FR 3 088 483 A1 divulgue un JoFET ayant des zones supraconductrices 19a, 19b à base de siliciure. Néanmoins, ces régions 19a,19b sont formées par réaction de la couche semi-conductrice 4 avec la couche métallique 17. Ainsi, il n y a pas une étape d'implantation des dopants, une réaction entre deux couches telle qu'écrite par FR 3 088 483 A1 étant distincte d'une implantation des dopants dans un matériau par un faisceau des particules.

### EXPOSÉ DE L'INVENTION

Un but de la présente invention est de proposer un procédé de réalisation d'un dispositif électronique à qubit(s) supraconducteur(s) incluant au moins un JoFET, pouvant être mis en oeuvre avec des techniques utilisées dans le domaine des semi-conducteurs.

Pour cela, la présente invention propose un procédé de réalisation d'un dispositif électronique à qubit(s) supraconducteur(s) incluant au moins un JoFET formé par la mise en oeuvre des étapes de :
- réalisation, sur au moins une couche de semi-conducteur, d'au moins une portion diélectrique de protection disposée sur au moins une première région de la couche de semi-conducteur ;
- implantation de dopants dans des deuxièmes régions de la couche de semi-conducteur, adjacentes à la première région et telles que la première région soit disposée entre les deuxièmes régions ;
- dépôt d'une couche diélectrique de protection recouvrant au moins la portion diélectrique de protection et les deuxièmes régions ;
- exposition de la couche diélectrique de protection à au moins une impulsion laser;
- retrait d'au moins une partie de la couche diélectrique de protection recouvrant les deuxièmes régions ;
- retrait de la portion diélectrique de protection ;
- réalisation d'au moins une grille de contrôle électrostatique sur la première région ;
et dans lequel les matériaux et les épaisseurs de la portion diélectrique de protection et de la couche diélectrique de protection, ainsi que la durée et la puissance de ladite au moins une impulsion laser, sont choisis tels que la superposition de la portion diélectrique de protection et de la couche diélectrique de protection sur la première région empêche ladite au moins une impulsion laser d'atteindre la première région, et que la présence de la couche diélectrique de protection seule sur les deuxièmes régions permette à ladite au moins une impulsion laser d'atteindre les deuxièmes régions et de fondre le semi-conducteur des deuxièmes régions qui forme, après un refroidissement, un matériau semi-conducteur recristallisé possédant des propriétés de matériau supraconducteur.

Ainsi, ce procédé propose la réalisation d'un dispositif électronique à un ou plusieurs qubits supraconducteurs incluant un ou plusieurs JoFETs réalisés dans une couche de semi-conducteur. Plus particulièrement, le procédé selon l'invention propose de réaliser les régions supraconductrices du ou des JoFETs en appliquant le principe d'épitaxie induite par laser pulsé ou PLIE pour « Pulsed Laser Induced Epitaxy », qui consiste à réaliser une implantation de dopants dans le matériau semi-conducteur correspondant par exemple à du silicium d'un substrat Bulk (massif) ou SOI (silicium sur isolant). Le matériau semi-conducteur dans lequel l'implantation de dopants a été réalisée est ensuite soumis à une ou plusieurs impulsions laser faisant fondre le matériau semi-conducteur. Le refroidissement du matériau semi-conducteur entraîne sa recristallisation qui lui confère des propriétés supraconductrices.

Dans le procédé selon l'invention, au moins une portion diélectrique de protection et une couche diélectrique de protection sont judicieusement choisies et réalisées pour permettre à la fois de fondre par impulsion(s) laser le semi-conducteur dans lequel les dopants sont implantés pour former des régions supraconductrices, et de protéger de la ou des impulsions laser au moins une première région de la couche de semi-conducteur destinée à former la jonction entre les régions supraconductrices.

La portion diélectrique de protection peut comporter du SiN, et la couche diélectrique de protection peut comporter du SiN et/ou du SiCO et/ou du SiO₂.

La portion diélectrique de protection peut être réalisée en déposant tout d'abord une couche de matériau diélectrique sur la couche de semi-conducteur, puis en gravant cette couche telle qu'au moins une portion restante de cette couche forme la portion diélectrique de protection.

Le choix des matériaux et des épaisseurs de la portion diélectrique de protection et de la couche diélectrique de protection peut être réalisé :
- en choisissant le matériau et l'épaisseur de la couche diélectrique de protection tels que la couche diélectrique de protection présente une réflectivité, vis-à-vis de la longueur d'onde de ladite au moins une impulsion laser, inférieure ou égale à 10 %, ou inférieure ou égale à 15%, puis
- en choisissant le matériau et l'épaisseur de la portion diélectrique de protection tels que la superposition de la portion diélectrique de protection et de la couche diélectrique de protection présente une réflectivité, vis-à-vis de la longueur d'onde de ladite au moins une impulsion laser, supérieure ou égale à 50 %, ou supérieure ou égale à 55 %.

Le procédé peut être tel que :
- la couche diélectrique de protection est déposée de manière conforme, et
- le retrait d'au moins une partie de la couche diélectrique de protection recouvrant les deuxièmes régions est réalisé en mettant en oeuvre une gravure anisotrope de la couche diélectrique de protection telle que des portions restantes de la couche diélectrique de protection forment des espaceurs diélectriques latéraux disposés contre des flancs latéraux de la portion diélectrique de protection.

Le procédé peut comporter en outre, entre la réalisation de la portion diélectrique de protection et l'implantation des dopants dans les deuxièmes régions :
- dépôt conforme d'une deuxième couche diélectrique recouvrant au moins la portion diélectrique de protection et les deuxièmes régions ;
- gravure anisotrope de la deuxième couche diélectrique telle que des portions restantes de la deuxième couche diélectrique recouvrent des flancs latéraux de la portion diélectrique de protection et soient disposées sur la première région (et plus précisément sur des bords de la première région) ;
- épitaxie de semi-conducteur sur les deuxièmes régions ;
et la couche diélectrique de protection déposée peut recouvrir également les portions restantes de la deuxième couche diélectrique.

Le semi-conducteur formé par épitaxie vient compléter le semi-conducteur existant des deuxièmes régions et fait partie de ces deuxièmes régions.

Dans le cas ci-dessus :
- la couche diélectrique de protection peut être déposée de manière conforme, et le retrait d'au moins une partie de la couche diélectrique de protection recouvrant les deuxièmes régions peut être réalisée en mettant en oeuvre une gravure anisotrope de la couche diélectrique de protection, des portions restantes de la couche diélectrique de protection formant, avec les portions restantes de la deuxième couche diélectrique, des espaceurs diélectriques latéraux disposés contre des flancs latéraux de la portion diélectrique de protection, ou
- le retrait d'au moins une partie de la couche diélectrique de protection peut correspondre à un retrait total de la couche diélectrique de protection.

Le procédé peut comporter en outre, entre la réalisation de la portion diélectrique de protection et l'implantation des dopants dans les deuxièmes régions :
- dépôt conforme d'une troisième couche diélectrique recouvrant au moins la portion diélectrique de protection et les deuxièmes régions, et dont l'épaisseur est égale au moins à celle de la couche diélectrique de protection formée ultérieurement ;
- gravure anisotrope de la troisième couche diélectrique telle que des portions restantes de la troisième couche diélectrique recouvrent des flancs latéraux de la portion diélectrique de protection et soient disposées sur la première région (ces portions restantes de la troisième couche diélectriques présentent alors une dimension, correspondant à l'épaisseur de la troisième couche diélectrique, qui soit égale au moins à l'épaisseur de la couche diélectrique de protection formée ultérieurement);
et peut comporter en outre, entre l'implantation des dopants dans les deuxièmes régions et le dépôt de la couche diélectrique de protection, un retrait des portions restantes de la troisième couche diélectrique.

Dans ce cas, le procédé peut comporter en outre, entre le retrait d'au moins une partie de la couche diélectrique de protection recouvrant les deuxièmes régions et le retrait de la portion diélectrique de protection, une réalisation d'espaceurs diélectriques latéraux contre des portions restantes de la couche diélectrique de protection, et la réalisation de la grille de contrôle électrostatique peut être précédée d'un retrait des portions restantes de la couche diélectrique de protection.

La couche de semi-conducteur peut correspondre à une couche superficielle d'un substrat de type semi-conducteur sur isolant, par exemple de type SOI (silicium sur isolant).

Dans ce cas, les dopants peuvent être implantés dans toute l'épaisseur de la couche de semi-conducteur, ou les dopants peuvent être implantés dans une partie seulement de l'épaisseur de la couche de semi-conducteur.

Les dopants peuvent correspondre à des atomes de bore implantés avec une dose comprise entre 1.10¹⁶ et 9.10¹⁷ at/cm².

Le procédé peut comporter en outre, avant la réalisation de la portion diélectrique de protection, la réalisation de tranchées d'isolation à travers au moins une partie de l'épaisseur de la couche de semi-conducteur, et les étapes ensuite mises en oeuvre peuvent former plusieurs JoFETs isolés électriquement les uns des autres par les tranchées d'isolation.

Les étapes mises en oeuvre peuvent former plusieurs JoFETs couplés électriquement en série par l'intermédiaire de deuxièmes régions communes à deux desdits JoFETs.

Le procédé peut comporter en outre la réalisation, dans la couche de semi-conducteur, de dispositifs à qubits de spin et/ou de dispositifs de type CMOS et/ou d'au moins une chaîne d'Andreev comportant d'autres régions (c'est-à-dire distinctes des deuxièmes régions) de semi-conducteur recristallisé possédant des propriétés de matériau supraconducteur.

Dans l'ensemble du document, le terme « sur » est utilisé sans distinction de l'orientation dans l'espace de l'élément auquel ce rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

Dans l'ensemble du document, le terme « couche » est utilisé pour désigner une couche seule, mais également une superposition de plusieurs couches distinctes.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 11 représentent un premier procédé de réalisation d'un dispositif électronique à qubit(s) supraconducteur(s) incluant au moins un JoFET, objet de la présente invention ;
- la figure 12 représente une variante de réalisation d'un dispositif électronique à qubit(s) supraconducteur(s) incluant au moins un JoFET ;
- les figures 13 à 23 représentent un deuxième procédé de réalisation d'un dispositif électronique à qubit(s) supraconducteur(s) incluant au moins un JoFET, objet de la présente invention ;
- les figures 24 à 33 représentent un troisième procédé de réalisation d'un dispositif électronique à qubit(s) supraconducteur(s) incluant au moins un JoFET, objet de la présente invention ;
- les figures 34 à 36 représentent différents exemples de réalisation de dispositifs électroniques à qubit(s) supraconducteur(s) intégrés sur un substrat semi-conducteur dans lequel d'autres types de dispositifs semi-conducteurs ont été réalisés.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

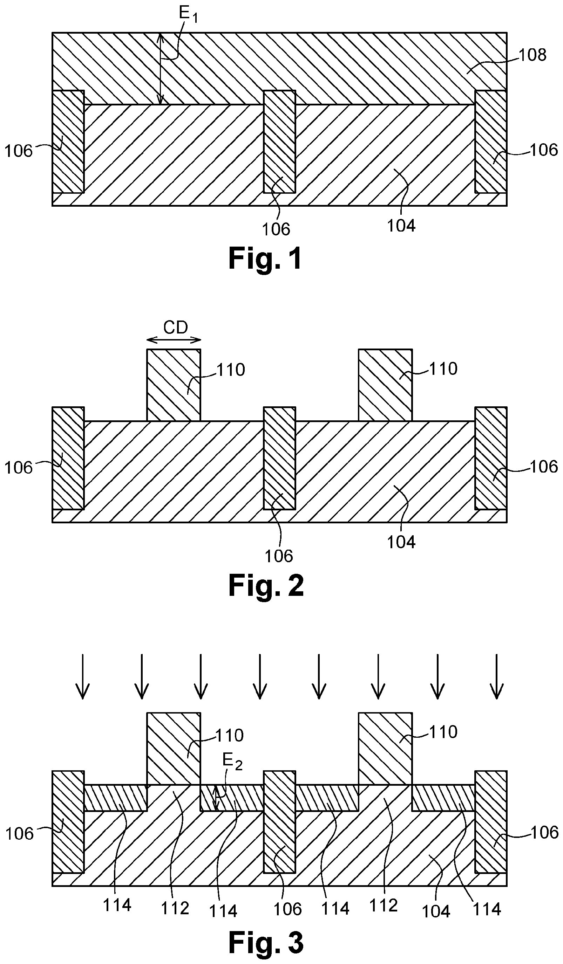

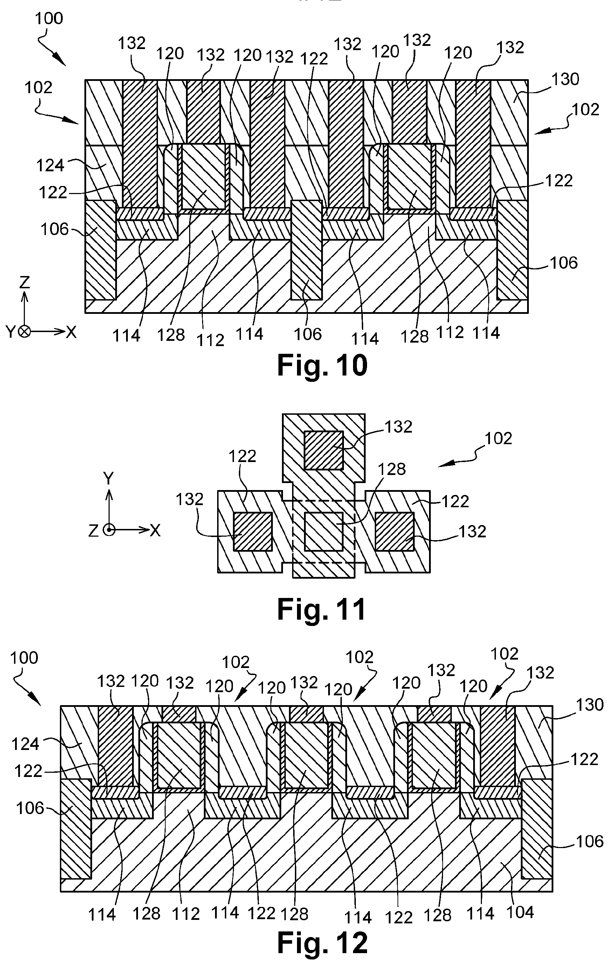

Un premier procédé de réalisation d'un dispositif électronique 100 à qubit(s) supraconducteur(s) incluant au moins un JoFET 102 est décrit ci-dessous en lien avec les figures 1 à 11. Dans l'exemple décrit en lien avec ces figures, le dispositif 100, visible sur la figure 10, comporte plusieurs JoFETs 102, et deux de ces JoFETs 102 sont visibles.

Dans ce premier procédé, le dispositif 100 est réalisé à partir d'un substrat massif 104, ou bulk, de semi-conducteur, ici du silicium (d'autres semi-conducteurs sont possibles, comme par exemple du germanium ou du SiGe).

Dans une première étape, des tranchées d'isolation 106 de type STI (« Shallow Trench Isolation » en anglais, ou tranchée d'isolation peu profonde) sont réalisées dans le substrat 104, délimitant les régions du substrat 104 dans lesquelles chacun des JoFETs 102 va être réalisé. Les étapes mises en oeuvre pour réaliser les tranchées 106 sont similaires à celles classiquement mises en oeuvre lors de la réalisation de transistors MOSFET isolés électriquement par de telles tranchées.

Une couche 108 de matériau diélectrique est ensuite déposée sur le substrat 104, en recouvrant également les tranchées 106 (voir figure 1). Dans l'exemple de réalisation décrit ici, la couche 108 comporte du SiN et son épaisseur E₁ est comprise entre 25 nm et 60 nm. Le choix de l'épaisseur et du matériau de la couche 108 est décrit plus loin.

La couche 108 est ensuite gravée de manière à ce que des portions restantes de cette couche 108 forment des portions diélectriques de protection 110 qui serviront ultérieurement à préserver les parties du substrat 104 recouvertes par ces portions 110 vis-à-vis d'une implantation de dopants et d'une exposition à un faisceau laser. Ces portions 110 forment également des grilles factices (« dummy gates » en anglais) occupant, sur le substrat 104, des emplacements sur lesquels les grilles des JoFETs 102 seront ultérieurement réalisées. Ces portions 110 ont une dimension critique qui déterminera la longueur de grille des JoFETs 102. Cette dimension critique est notée « CD » sur la figure 2 et est par exemple comprise entre 20 nm et 50 nm.

Une étape de nettoyage est mise en oeuvre après la réalisation des portions 110.

Une étape d'implantation de dopants est ensuite mise en oeuvre à travers la surface du substrat 104 sur laquelle repose les portions 110. Dans l'exemple de réalisation décrit ici, les dopants implantés sont des atomes de bore. La dose avec laquelle cette implantation est mise en oeuvre est par exemple comprise entre 1.10¹⁶ et 9.10¹⁷ at/cm². L'énergie avec laquelle cette implantation est mise en oeuvre est choisie en fonction d'une épaisseur E₂ souhaitée dans laquelle les atomes dopants sont implantés. Cette épaisseur E₂ est par exemple comprise entre 5 nm et 25 nm. Les flèches visibles sur la figure 3 représentent symboliquement la direction d'implantation des atomes dopants dans le substrat 104.

Lors de cette étape d'implantation, les régions du substrat 104 recouvertes par les portions 110, appelées premières régions 112, sont protégées et les atomes dopants ne sont pas implantés dans ces premières régions 112. Ainsi, l'épaisseur et le matériau de la couche 108 sont choisis de manière à ce que les portions 110 obtenues à partir de cette couche permettent d'obtenir cette protection.

Les atomes dopants sont par contre implantés dans les régions du substrat 104 non recouvertes par les portions 110, appelées deuxièmes régions 114. Avec cette implantation, le semi-conducteur des deuxièmes régions 114 devient amorphe. L'épaisseur E₂ correspond à l'épaisseur de ces deuxièmes régions 114. De plus, avec cette étape d'implantation, les flancs latéraux des portions 110 sont disposés à l'aplomb, ou sont alignés avec, des bords des deuxièmes régions 114 et des premières régions 112. Dans la structure obtenue visible sur la figure 3, deux deuxièmes régions 114 sont adjacentes à chaque première région 112 qui est disposée entre ces deux deuxièmes régions 114.

Après cette implantation de dopants dans les deuxièmes régions 114, la structure peut subir de nouveau une étape de nettoyage.

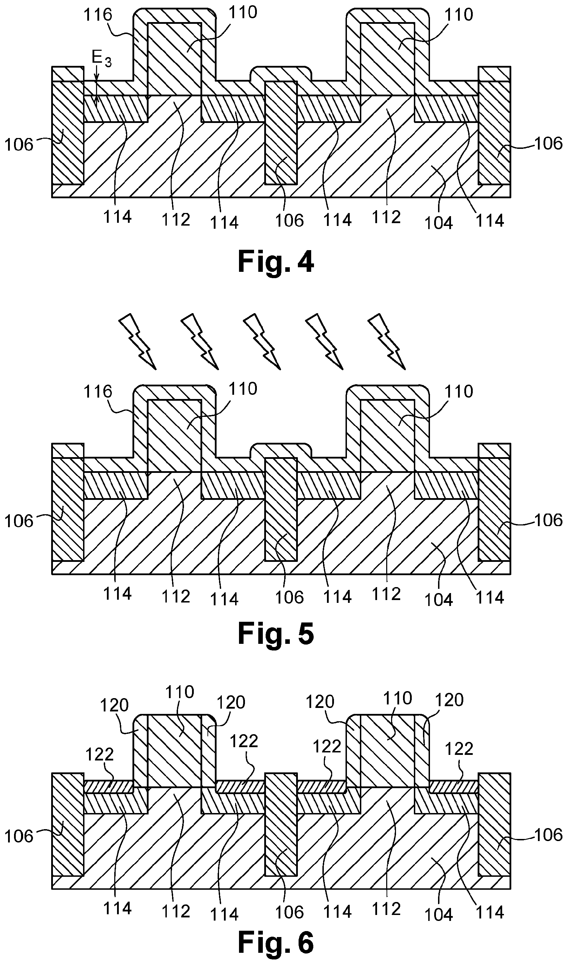

Une couche diélectrique de protection 116 est ensuite déposée de manière conforme sur l'ensemble de la structure, c'est-à-dire en recouvrant les portions 110 (les faces supérieures et les flancs latéraux des portions 110), les tranchées d'isolation 106 et les deuxièmes régions 114 (voir figure 4). Dans l'exemple de réalisation décrit ici, la couche 116 comporte du SiCO ou du SiOz ou du SiN, et son épaisseur E₃ est comprise entre 15 nm et 40 nm. Le choix de l'épaisseur et du matériau de la couche 116 est fait de manière à ce qu'une étape ultérieure d'exposition de la structure réalisée à une ou plusieurs impulsions laser fasse fondre le matériau des deuxièmes régions 114, qui est recouvert seulement par la couche 116, mais pas le matériau des premières régions 112, qui est recouvert par les portions 110 et la couche 116.

La structure réalisée est ensuite exposée à une ou plusieurs impulsions laser qui font fondre le matériau des deuxièmes régions 114. En utilisant par exemple un laser émettant des longueurs d'onde dans le domaine de l'ultraviolet, par exemple 193 nm, 248 nm, 308 nm ou encore 355 nm, les durées d'impulsions peuvent être typiquement comprises entre environ 20 ns et 200 ns, préférentiellement entre environ 60 ns et 180 ns. Les gammes de densité d'énergie associées sont alors typiquement comprises entre environ 0,1 et 2 J/cm², plus particulièrement entre environ 0,3 et 1,5 J/cm². A noter que pour un même résultat, une densité moindre sera nécessaire si la durée d'impulsion est faible. Après avoir été exposé à la ou aux impulsions laser (dose par exemple comprise entre 0,6 et 2 J/cm², pour laser de longueur d'onde égale à 308 nm), le semi-conducteur amorphe fondu des deuxièmes régions 114 recristallise, après un refroidissement, en un matériau semi-conducteur possédant des propriétés de matériau supraconducteur. Dans l'exemple de réalisation décrit ici, le matériau recristallisé correspond à du Si:B qui possède des propriétés supraconductrices lorsque le pourcentage d'atome de bore est supérieur à environ 4 ou 5 %. En outre, en fonction de la nature du matériau localisé sous les deuxièmes régions 114 implanté (du semi-conducteur dans le cas d'un substrat bulk, ou un oxyde enterré dans le cas d'un substrat FDSOI), le semi-conducteur recristallisé des deuxièmes régions 114 est polycristallin ou monocristallin.

Lors de l'exposition de la structure à la ou aux impulsions laser, la superposition des portions 110 et de la couche 116 empêche le faisceau laser utilisé de pénétrer jusqu'aux premières régions 112. Le semi-conducteur des premières régions 112 n'est donc pas modifié par le laser utilisé pour conférer des propriétés supraconductrices au semi-conducteur des deuxièmes régions 114.

La couche 116 est ensuite gravée de manière anisotrope afin de supprimer les parties de la couche 116 se trouvant sur les tranchées d'isolation 106, les deuxièmes régions 114 et sur les sommets des portions 110, tout en conservant des portions 120 de la couche 116 recouvrant les flancs latéraux des portions 110 et qui sont destinées à former les espaceurs latéraux autour des futures grilles des JoFETs 102.

En variante, et notamment lorsque le matériau de la couche 116 n'est pas adapté pour former les espaceurs latéraux souhaités, il est possible de graver complètement la couche 116, puis de déposer une ou plusieurs nouvelles couches de matériaux sur l'ensemble de la structure, puis graver de manière anisotrope cette ou ces nouvelles couches de matériaux afin de ne conserver que les parties de cette ou ces nouvelles couches disposées recouvrant les flancs latéraux des portions 110 et formant les futurs espaceurs latéraux des grilles des JoFETs 102.

Une siliciuration des deuxièmes régions 114 est ensuite mise en oeuvre. Cette siliciuration est par exemple mise en oeuvre en utilisant du nickel. La présence des portions 120 permet d'obtenir un bon positionnement des portions de siliciure 122 obtenues par rapport aux futures grilles des JoFETs 102, c'est-à-dire espacées d'une distance non nulle de ces futures grilles (voir figure 6).

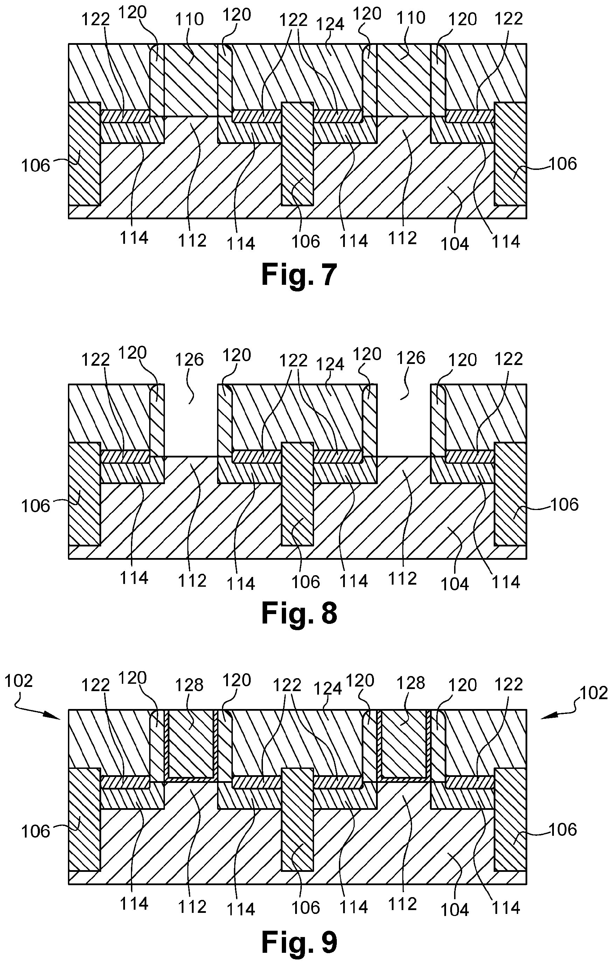

Au moins une autre couche diélectrique 124 est ensuite déposée sur l'ensemble de la structure. Cette couche 124 comporte par exemple du SiOz, ou correspond à une superposition d'un oxyde et d'un matériau diélectrique dit « low-k », ou à faible permittivité. L'épaisseur de la couche 124 est supérieure à l'épaisseur E₁ des portions 110. Une planarisation mécano-chimique avec arrêt sur les portions 110 est ensuite mise en oeuvre (voir figure 7).

Les portions 110 sont ensuite retirées par gravure sélective vis-à-vis des matériaux des portions 120 et de la couche 124 (voir figure 8). Dans l'exemple de réalisation décrit ici, cette gravure peut correspondre à une gravure humide mise en oeuvre avec une solution de H₃PO₄ permettant de graver le SiN des portions 110 sélectivement vis-à-vis du SiOz ou du SiCO des portions 120 et du SiOz de la couche diélectrique 124 ou du Si (ou SiGe) des zones 112. Le retrait des portions 110 forme des espaces vides 126 entourés par les portions 120.

Les grilles des JoFETs 102 sont ensuite réalisées. Pour cela, une étape de nettoyage est mise en oeuvre, suivie d'une étape de réalisation d'au moins une couche de diélectrique de grille déposée de manière conforme contre les parois des espaces vides 126 (parois de fond et parois latérales) et sur la couche 124, puis le dépôt d'un ou plusieurs matériaux électriquement conducteurs dans le volume restant des espaces vides 126 sur la couche 124 avec une épaisseur suffisante pour remplir le volume restant des espaces vides 126. Par exemple, la couche de diélectrique de grille peut correspondre à une couche de SiO₂ formée par oxydation thermique ou par dépôt, ou bien un matériau diélectrique « High K », ou à forte permittivité diélectrique, comme par exemple du HfOz. Selon un exemple, les matériaux électriquement conducteurs déposés pour former les grilles des JoFETs 102 correspondent à une couche de TiN recouverte d'une couche plus épaisse de tungstène.

Une planarisation mécano-chimique est ensuite mise en oeuvre afin de supprimer les parties de la couche de diélectrique de grille et des matériaux électriquement conducteurs se trouvant en dehors des espaces vides 126, formant ainsi les grilles 128 des JoFETs 102, ces grilles 128 étant localisées sur les premières régions 112 (voir figure 9).

La réalisation du dispositif 100 est achevée en déposant au moins une couche diélectrique PMD (diélectrique pré-métallique) 130, comprenant par exemple du SiOz, sur l'ensemble de la structure réalisée, puis en gravant des trous de contact à travers cette couche 130, et également à travers la couche 124 pour certains de ces trous. Les trous gravés sont ensuite remplis par un ou plusieurs matériaux électriquement conducteurs, formant des contacts électriques 132 reliés aux portions de siliciure 122 (ces contacts électriques 132 traversent les couches 124 et 130) et aux grilles 128 (ces contacts électriques 132 traversent uniquement la couche 130). Le dispositif 100 achevé est visible sur la figure 10. Une vue de dessus d'un des deux JoFETs 102 du dispositif 100 est visible sur la figure 11.

Dans l'exemple de procédé précédemment décrit, les JoFETs 102 sont isolés électriquement l'un de l'autre par les tranchées d'isolation 106. En alternative ou en combinaison de ces JoFETs 102, les étapes de ce procédé peuvent réaliser plusieurs JoFETs 102 reliés électriquement en série par l'intermédiaire de deuxièmes régions 114 qui sont communes à deux JoFETs 102 voisins. Une telle configuration est visible sur la figure 12 sur laquelle trois JoFETs 102 couplés électriquement en série l'un à l'autre sont représentés. Sur l'exemple de la figure 12, aucun contact électrique n'est relié aux deuxièmes portions modifiées 118 communes à deux JoFETs 102 voisins.

Comme indiqué précédemment, préalablement à la mise en oeuvre des dépôts des couches 108 et 116, l'épaisseur et le matériau de ces couches 108 et 116 sont choisis de manière à ce que l'étape d'exposition de la structure à une ou plusieurs impulsions laser fasse fondre le matériau des deuxièmes régions 114, qui est recouvert seulement par la couche 116, mais pas le matériau des premières régions 112, qui est recouvert par les portions 110 de la couche 108 et la couche 116.

Pour cela, l'épaisseur et le matériau de la couche 116 sont tout d'abord choisis de manière à ce que cette couche présente une faible réflectivité, par exemple inférieure ou égale à environ 15 %, ou inférieure ou égale à environ 10 %, vis-à-vis de la longueur d'onde du laser utilisé pour faire fondre le semi-conducteur des deuxièmes régions 114. Selon un premier exemple de réalisation particulier, lorsque le laser utilisé pour faire fondre le semi-conducteur des deuxièmes régions 114 a une longueur d'onde égale à 308 nm, une faible réflectivité vis-à-vis de ce laser est obtenue avec une couche 116 comportant du SiN et une épaisseur E₃ comprise entre 25 nm et 35 nm, par exemple égale à 30 nm. Selon un deuxième exemple de réalisation particulier, lorsque le laser utilisé pour faire fondre le semi-conducteur des deuxièmes régions 114 a également une longueur d'onde égale à 308 nm, la couche 116 peut comporter du SiOz et une épaisseur E₃ comprise entre 30 nm et 40 nm, par exemple égale à 35 nm.

Après avoir choisi l'épaisseur et le matériau de la couche 116, l'épaisseur et le matériau de la couche 108 sont choisis de manière à ce que la superposition des matériaux des couches 108, 116 sur les premières régions 112 présente une forte réflectivité, par exemple supérieure ou égale à environ 50 %, ou supérieure ou égale à environ 55 %, vis-à-vis de la longueur d'onde du laser utilisé pour faire fondre le semi-conducteur des deuxièmes régions 114 et protège ainsi les premières régions 112 de manière à ce que le matériau des premières régions 112 ne fonde pas lorsqu'il est exposé à ce laser. Il convient de noter qu'en choisissant ainsi l'épaisseur et le matériau de la couche 108, le semi-conducteur des premières régions 112 est également préservé de l'implantation de dopants mise en oeuvre pour obtenir les deuxièmes régions 114. Selon le premier exemple de réaliser particulier indiqué ci-dessus, la couche 108 peut comporter également du SiN et une épaisseur E₁ comprise entre 25 nm et 45 nm. Selon le deuxième exemple de réaliser particulier indiqué ci-dessus, la couche 108 peut comporter également du SiN et une épaisseur E₁ comprise entre 50 nm et 60 nm.

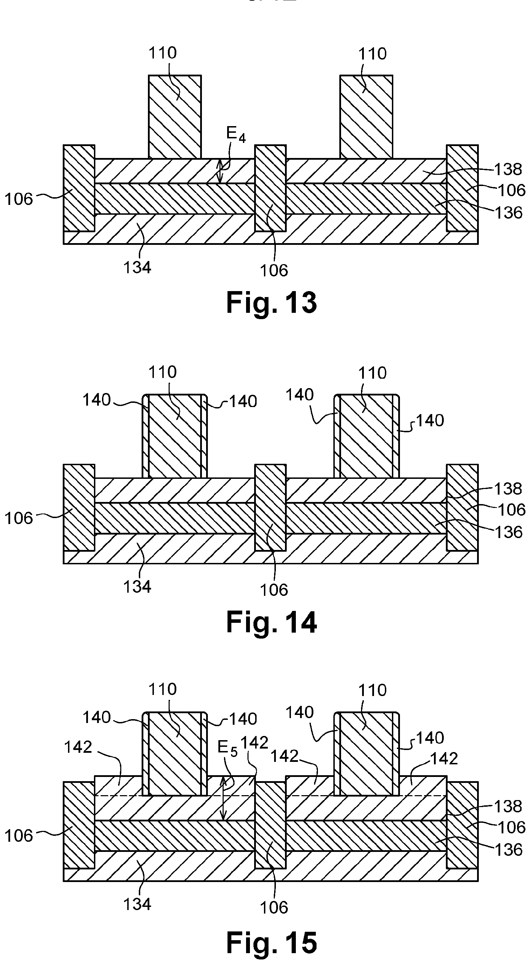

Un deuxième procédé de réalisation d'un dispositif électronique 100 à qubit(s) supraconducteur(s) incluant au moins un JoFET 102 est décrit ci-dessous en lien avec les figures 13 à 23. Dans l'exemple décrit en lien avec ces figures, le dispositif 100 comporte plusieurs JoFETs 102, et deux de ces JoFETs 102 sont visibles sur ces figures.

Dans ce deuxième procédé, le dispositif 100 est réalisé à partir d'un substrat de type semi-conducteur sur isolant, ici SOI (silicium sur isolant). De manière avantageuse, ce substrat est de type FDSOI (silicium sur isolant complètement déserté, ou silicium sur isolant complètement déplété). Ce substrat comporte une couche massive 134, ou couche support, sur laquelle est disposée une couche diélectrique enterrée 136, ou BOX. Une couche superficielle de semi-conducteur 138, ici de silicium, est disposée sur la couche diélectrique enterrée 136. L'épaisseur E₄ de la couche superficielle 138 est avantageusement inférieure ou égale à environ 12 nm, voire inférieure ou égale à environ 7 nm.

Comme dans le premier procédé de réalisation précédemment décrit, des tranchées d'isolation 106 de type STI sont réalisées dans le substrat (à travers les couches 138 et 136, et une partie de l'épaisseur de la couche 134), délimitant les régions du substrat dans lesquelles chacun des JoFETs 102 va être réalisé.

La couche 108 de matériau diélectrique est ensuite déposée sur le substrat en recouvrant également les tranchées 106, puis est ensuite gravée de manière à former les portions 110 qui serviront à délimiter les premières et deuxièmes régions 112, 114 qui seront obtenues dans la couche superficielle 138 (voir figure 13). La couche 108 est par exemple similaire à celle précédemment décrite pour le premier procédé de réalisation. Une étape de nettoyage est mise en oeuvre après la réalisation des portions 110.

Une autre couche diélectrique, appelée par exemple deuxième couche diélectrique, comprenant par exemple du SiOz, est ensuite déposée de manière conforme sur l'ensemble de la structure, c'est-à-dire sur le substrat, les tranchées 106 et les portions 110 (parois supérieures et latérales). Une gravure anisotrope est ensuite mise en oeuvre afin de ne conserver que des portions restantes 140 de cette deuxième couche diélectrique, ces portions 140 recouvrant les flancs latéraux des portions 110 et étant destinées à former ou à faire partie des espaceurs latéraux des JoFETs 102 (voir figure 14).

Dans l'exemple décrit ici, dans lequel le substrat est de type FDSOI, pour obtenir un bon fonctionnement du dispositif 100, le procédé est mis en oeuvre tel que les premières régions 112 aient une épaisseur différente de celle des deuxièmes régions 114. Plus particulièrement, afin que les grilles 128 puissent réaliser un bon contrôle électrostatique de la conductivité des premières régions 112, ces premières régions 112 sont réalisées avec une épaisseur inférieure ou égale à environ 12 nm, voire inférieure ou égale à environ 7 nm. Par contre, pour que les deuxièmes régions 114 aient de bonnes propriétés supraconductrices, les deuxièmes régions 114 sont réalisées avec une épaisseur supérieure ou égale à environ 15 nm, ou supérieure ou égale à environ 20 nm.

Pour obtenir cette différence d'épaisseur entre les premières et deuxièmes régions 112 et 114, une étape d'épitaxie de semi-conducteur (de silicium dans l'exemple décrit ici) est mise en oeuvre afin de faire croître ce semi-conducteur dans les parties de la couche 138 non recouvertes par les portions 110 et 140 jusqu'à atteindre une épaisseur permettant ultérieurement d'obtenir des deuxièmes régions 114 ayant les propriétés supraconductrices souhaitées. Selon un exemple de réalisation, cette étape d'épitaxie est mise en oeuvre de manière à faire croître une épaisseur de semi-conducteur comprise entre environ 5 nm et 25 nm, ce qui permet l'obtention d'une épaisseur totale E₅ de semi-conducteur, au niveau des futures régions de semi-conducteur destinées à être fondues, comprise entre environ 17 nm et 30 nm. Sur la figure 15, le semi-conducteur obtenu par la mise en oeuvre de cette étape de croissance est désigné par la référence 142. Du fait de la présence des portions 140 autour des portions 110, le semi-conducteur 142 n'est pas en contact avec les portions 110, ce qui permettra, à l'issue du procédé, d'obtenir des deuxièmes régions 114 distantes des grilles 128, c'est-à-dire qui ne sont pas en contact avec les grilles 128.

Une étape de nettoyage est mise en oeuvre après cette épitaxie.

Comme dans le premier procédé précédemment décrit, une étape d'implantation de dopants est ensuite mise en oeuvre. Les parties de la couche 138 recouvertes par les portions 110 et 140 sont protégées et les atomes dopants ne sont pas implantés dans ces parties de la couche 138 formant les premières régions 112. Les atomes dopants sont par contre implantés dans les deuxièmes régions 114 de la couche 138 non recouvertes par les portions 110 et 140. Avec cette étape d'implantation, les bords latéraux extérieurs (ceux qui ne sont pas en contact avec les portions 110) des portions 140 sont disposés à l'aplomb, ou sont alignés avec, les bords des deuxièmes régions 114 et des premières régions 112.

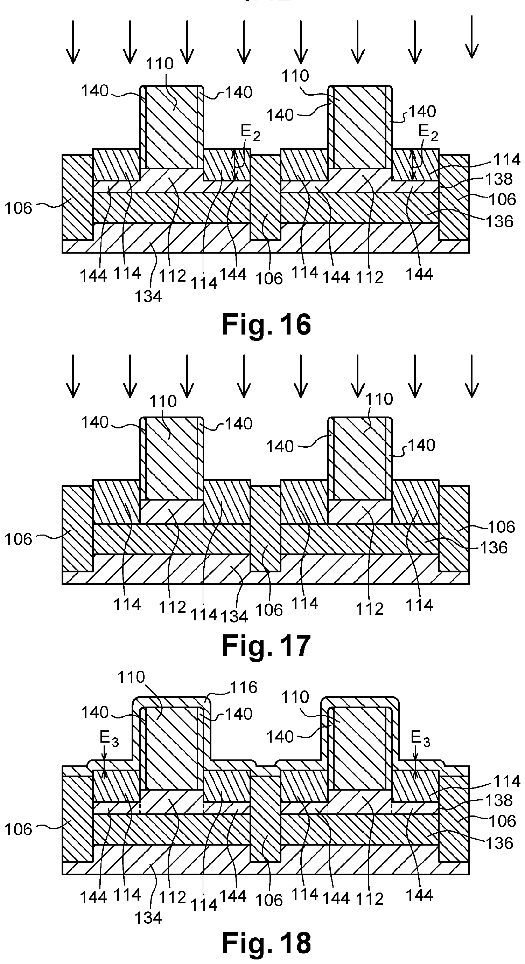

Dans l'exemple de réalisation visible sur la figure 16, les atomes dopants ne sont pas implantés dans toute l'épaisseur de la couche 138. Ainsi, des parties 144 de la couche 138 (délimitées symboliquement des premières régions 112 par des traits pointillés) présentes sous les deuxièmes régions 114 sont préservées de l'implantation de dopants mise en oeuvre et serviront ultérieurement de germe cristallin lors de la recristallisation du semi-conducteur fondu des deuxièmes régions 114, ce qui permettra au semi-conducteur recristallisé des deuxièmes régions 114 d'être monocristallin en raison du caractère monocristallin du semi-conducteur des parties 144 de la couche 138 présent sous les deuxièmes régions 114.

En variante, il est possible que les atomes dopants soient implantés dans toute l'épaisseur de la couche 138. Dans ce cas, les deuxièmes régions 114 s'étendent depuis la surface de la couche 138 sur laquelle reposent les portions 110 et 140 jusqu'à la couche diélectrique enterrée 136 (voir figure 17). Dans ce cas, le matériau recristallisé des deuxièmes régions 118 sera polycristallin du fait que le semi-conducteur se recristallise sur le matériau diélectrique de la couche 136.

La suite du procédé est décrite en considérant que les étapes suivantes sont mises en oeuvre à partir de la structure représentée sur la figure 16, c'est-à-dire en ayant conservé les parties 144 de la couche 138 sous les deuxièmes régions 114. Ces étapes seraient toutefois mises en oeuvre de manière identique si les dopants étaient implantés dans toute l'épaisseur de la couche 138.

Après cette implantation, la structure peut subir de nouveau une étape de nettoyage. La couche diélectrique de protection 116 est ensuite déposée de manière conforme sur l'ensemble de la structure, comme précédemment décrit pour le premier procédé. Comme dans le premier procédé, l'épaisseur E₃ et le matériau de la couche 116 sont choisis de manière à ce qu'une étape ultérieure d'exposition de la structure réalisée à une ou plusieurs impulsions laser fasse fondre le matériau des deuxièmes régions 114, qui est recouvert seulement par la couche 116, mais pas le matériau des premières régions 112, qui est recouvert par les portions 110, 140 et la couche 116. En variante, il est possible que la couche 116 ne soit pas déposée de manière conforme, car en raison de la présence des portions 140, des parties de la couche 116 pourront être ultérieurement conservées ou non pour former, avec les portions 140, les espaceurs latéraux autour des grilles 128.

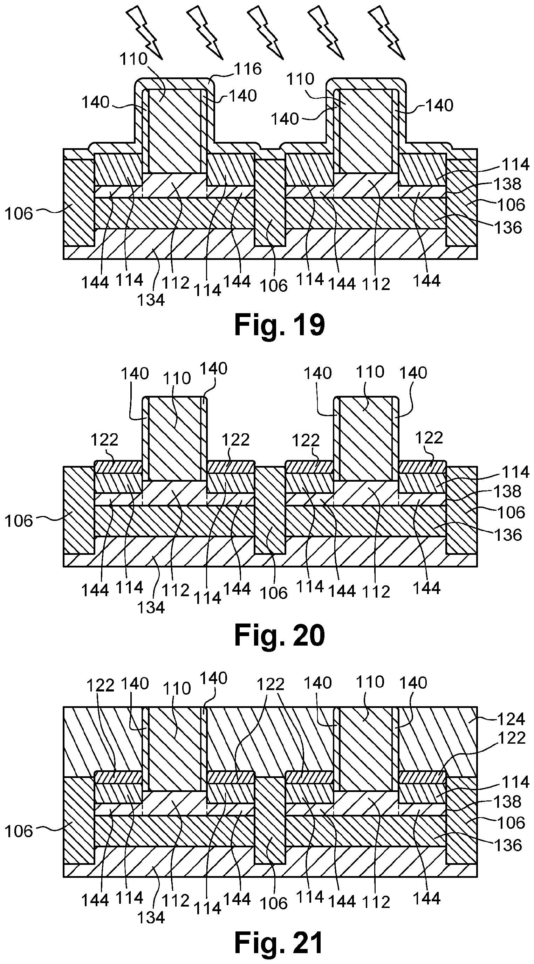

La structure réalisée est ensuite exposée à une ou plusieurs impulsions laser qui font fondre le matériau des deuxièmes régions 114 (voir figure 19). Après avoir été exposé à la ou aux impulsions laser, le semi-conducteur amorphe fondu des deuxièmes régions 114 recristallise en un matériau semi-conducteur (ici monocristallin en raison de présence des parties 144 de semi-conducteur monocristallin sous le semi-conducteur fondu des deuxièmes régions 114) possédant des propriétés de matériau supraconducteur.

La couche 116 est ensuite gravée soit complètement comme représenté sur la figure 20, soit comme précédemment décrit dans le premier procédé, c'est-à-dire en conservant des parties de la couche 116 recouvrant les flancs latéraux des portions 110 et qui sont destinées à former, avec les portions 140, les espaceurs latéraux autour des futures grilles des JoFETs 102. Il est également possible de graver complètement la couche 116, puis de déposer une ou plusieurs nouvelles couches de matériaux sur l'ensemble de la structure, puis graver de manière anisotrope cette ou ces nouvelles couches de matériaux afin de ne conserver que les parties de cette ou ces nouvelles couches recouvrant les flancs latéraux des portions 140 et formant, avec les portions 140, les espaceurs latéraux.

Comme dans le premier procédé, une siliciuration des deuxièmes régions 114 est ensuite mise en oeuvre (voir figure 20).

La couche diélectrique 124 est ensuite déposée sur l'ensemble de la structure, puis une planarisation mécano-chimique avec arrêt sur les portions 110 est ensuite mise en oeuvre (voir figure 21).

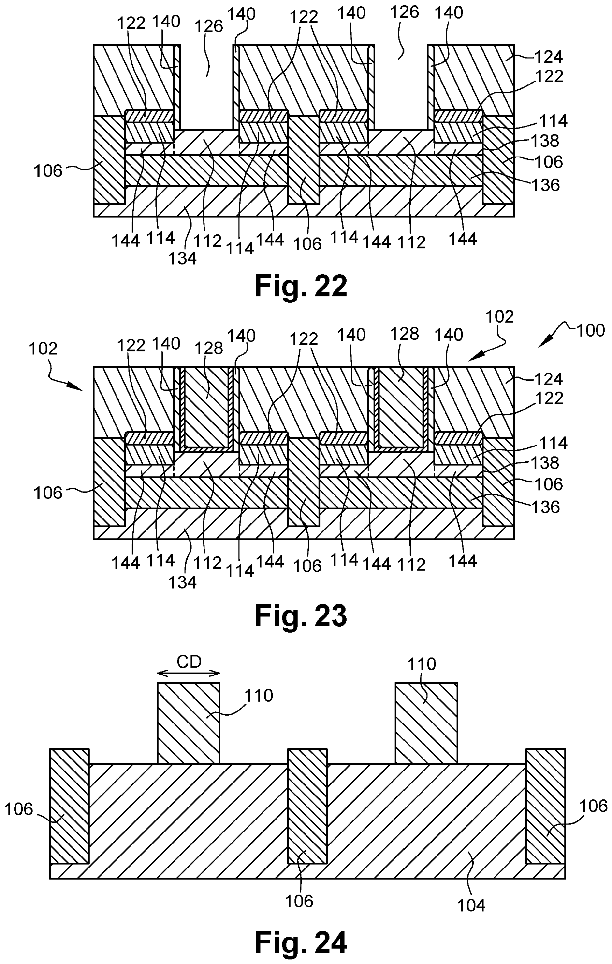

Les portions 110 sont ensuite retirées par gravure sélective vis-à-vis des matériaux des espaceurs latéraux, formés par les portions 140, et de la couche diélectrique 124 (voir figure 22). Le retrait des portions 110 forme les espaces vides 126 entourés par les portions 140.

Comme dans le premier procédé, les grilles 128 des JoFETs sont ensuite réalisées dans les espaces vides 126 (voir figure 23).

La réalisation du dispositif 100 est achevée comme dans le premier procédé précédemment décrit, c'est-à-dire en déposant au moins une couche diélectrique PMD sur l'ensemble de la structure réalisée, en gravant les trous de contact et en remplissant ces trous par un ou plusieurs matériaux électriquement conducteurs pour former les contacts électriques 132 reliés aux portions de siliciure 122 et aux grilles 128.

Comme pour le premier procédé, ce deuxième procédé peut s'appliquer pour réaliser un dispositif 100 comportant plusieurs JoFETs 102 reliés électriquement en série par leurs deuxièmes régions 114 communes à deux JoFETs 102 voisins.

Un troisième procédé de réalisation d'un dispositif électronique 100 à qubit(s) supraconducteur(s) incluant au moins un JoFET 102 est décrit ci-dessous en lien avec les figures 24 à 33. Dans l'exemple décrit en lien avec ces figures, le dispositif 100 comporte plusieurs JoFETs 102, et deux de ces JoFETs 102 sont visibles sur ces figures.

Comme dans le premier procédé, un substrat 104 de type bulk est utilisé. Les tranchées d'isolation 106 sont tout d'abord réalisées dans le substrat 104, délimitant les régions du substrat dans lesquelles chacun des JoFETs 102 va être réalisé.

La couche 108 est ensuite déposée sur le substrat 104 en recouvrant également les tranchées 106, puis est ensuite gravée de manière à former les portions 110 destinées à être disposées sur les premières régions 112 du substrat 104 (voir figure 24). La couche 108 est par exemple similaire à celle précédemment décrite pour les premier et deuxième procédés de réalisation. Une étape de nettoyage est mise en oeuvre après la réalisation des portions 110.

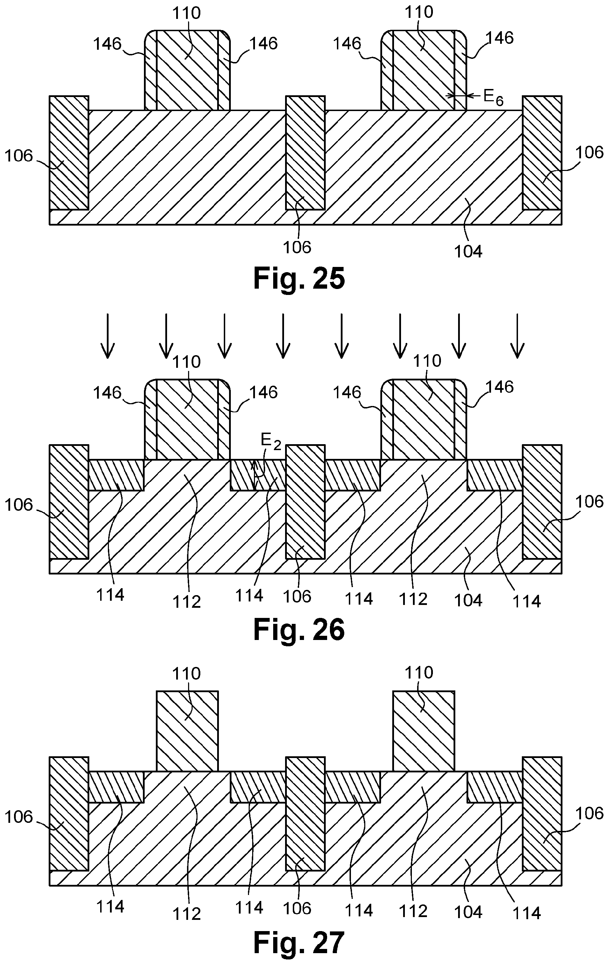

Une couche diélectrique, appelée par exemple troisième couche diélectrique et comprenant par exemple du SiOz, est ensuite déposée de manière conforme sur l'ensemble de la structure, c'est-à-dire sur le substrat 104, les tranchées 106 et les portions 110 (parois supérieures et latérales). L'épaisseur de cette troisième couche diélectrique est égale au moins à celle de la couche diélectrique de protection 116 qui sera formée ultérieurement. Une gravure anisotrope est ensuite mise en oeuvre afin de ne conserver que des portions restantes 146 de cette couche qui recouvrent les flancs latéraux des portions 110 et qui forment des espaceurs latéraux temporaires (voir figure 25). L'épaisseur E₆ des portions restantes 146 de la troisième couche diélectrique déposée est égale à celle des espaceurs latéraux définitifs destinés à être réalisés par la suite afin que les portions 146 occupent, sur le substrat 104, les emplacements qui seront par la suite occupés par les espaceurs latéraux définitifs des grilles 128 des JoFETs 102. Cette épaisseur E₆ est inférieure ou égale à l'épaisseur initiale de la troisième couche diélectrique déposée. En outre, cette épaisseur E₆ est choisie égale à l'épaisseur E₃ de la couche diélectrique de protection 116 qui sera utilisée ultérieurement au cours du procédé. Cette épaisseur E₆ est par exemple égale à environ 15 nm.

Une étape de nettoyage est mise en oeuvre après la gravure de la couche diélectrique formant les portions 146.

Comme dans le premier procédé précédemment décrit, une étape d'implantation de dopants est ensuite mise en oeuvre. Les premières régions 112 du substrat 104 recouvertes par les portions 110 et 146 sont protégées et les atomes dopants ne sont pas implantés dans ces premières régions 112. Les atomes dopants sont par contre implantés dans les deuxièmes régions 114 du substrat 104 non recouvertes par les portions 110 et 146. Avec cette étape d'implantation, les bords latéraux extérieurs (ceux qui ne sont pas en contact avec les portions 110) des portions 146 sont disposés à l'aplomb, ou sont alignés avec, les bords des deuxièmes régions 114, et les bords latéraux intérieurs (ceux en contact avec les portions 110) des portions 146 sont disposés à l'aplomb, ou sont alignés avec, les bords des premières régions 112 (voir figure 26).

Comme représenté sur la figure 27, les portions 146 sont ensuite retirées, par exemple par la mise en oeuvre d'une gravure humide utilisant une solution d'HF lorsque ces portions 146 comportent du SiO₂.

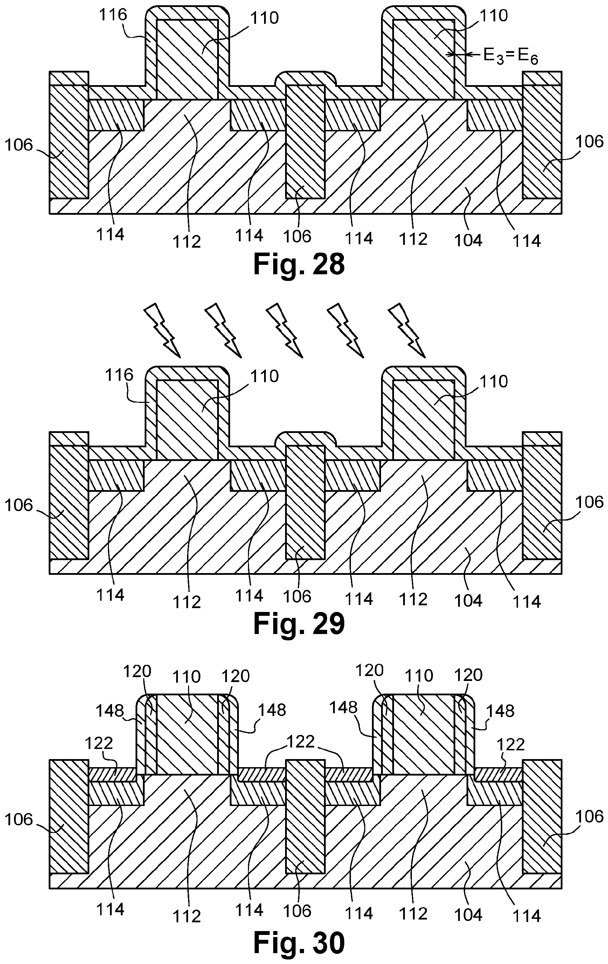

Après cette implantation, la structure peut subir de nouveau une étape de nettoyage. La couche 116 est ensuite déposée de manière conforme sur l'ensemble de la structure, comme précédemment décrit pour les premier et deuxième procédés (voir figure 28). Comme précédemment, l'épaisseur E₃ et le matériau de la deuxième couche 116 sont choisis de manière à ce qu'une étape ultérieure d'exposition de la structure réalisée à une ou plusieurs impulsions laser fasse fondre le semi-conducteur des deuxièmes régions 114, qui est recouvert seulement par la couche 116, mais pas le matériau des premières régions 112, qui est recouvert par les portions 110 et la deuxième couche 116.

La structure réalisée est ensuite exposée à une ou plusieurs impulsions laser qui font fondre le semi-conducteur des deuxièmes régions 114 (voir figure 29). Après avoir été exposé à la ou aux impulsions laser, le semi-conducteur amorphe fondu des deuxièmes régions 114 recristallise, après un refroidissement, en un matériau semi-conducteur possédant des propriétés de matériau supraconducteur. Le semi-conducteur des premières régions 112 auparavant recouvert par les portions 146 et qui est recouvert uniquement par la couche 116 est également protégé de cette ou ces impulsions laser en raison de l'épaisseur importante de matériau de la couche 116 présente sur ces portions de semi-conducteur.

La couche 116 est ensuite gravée de manière anisotrope de manière à conserver des parties de cette couche 116 recouvrant les flancs latéraux des portions 110 et qui sont destinées à former les espaceurs latéraux autour des futures grilles des JoFETs 102. En variante, et comme c'est le cas sur l'exemple représenté sur la figure 30, une autre couche de matériau est déposée sur l'ensemble de la structure, puis gravée de manière anisotrope afin de ne conserver que des parties 148 de cette ou ces nouvelles couches recouvrant les flancs latéraux des portions 116 et destinées à former les futurs espaceurs latéraux des grilles 128 des JoFETs 102.

Comme précédemment, une siliciuration des deuxièmes régions 114 est ensuite mise en oeuvre (voir figure 30).

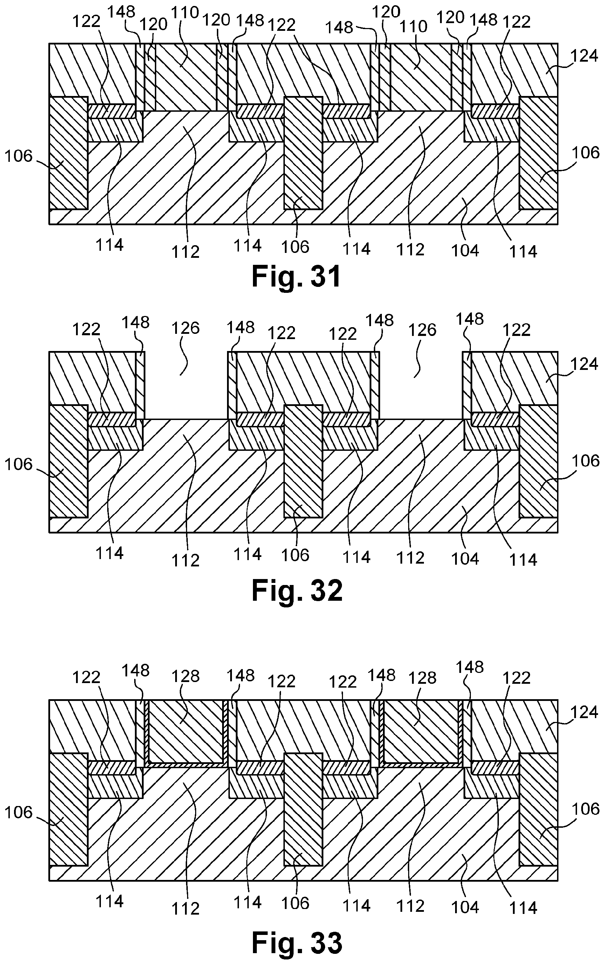

La couche diélectrique 124 est ensuite déposée sur l'ensemble de la structure, puis une planarisation mécano-chimique avec arrêt sur les portions 110 est ensuite mise en oeuvre (voir figure 31).

Les portions 110 et 120 sont ensuite retirées par gravure sélective vis-à-vis des matériaux des espaceurs latéraux, formés par les portions 148, et de la couche diélectrique 124 (voir figure 32). Cette gravure correspond par exemple à une gravure humide mise en oeuvre avec une solution de H₃PO₄ lorsque les portions 110 et 120 comportent du SiN. Le retrait des portions 110 et 120 forme les espaces vides 126 entourés par les portions 148.

Comme dans les précédents procédés, les grilles 128 des JoFETs 102 sont ensuite réalisées dans les espaces vides 126 (voir figure 33).

La réalisation du dispositif 100 est achevée comme dans les premier et deuxième procédés précédemment décrits, c'est-à-dire en déposant au moins une couche diélectrique PMD sur l'ensemble de la structure réalisée, en gravant les trous de contact et en remplissant ces trous par un ou plusieurs matériaux électriquement conducteurs pour former les contacts électriques 132 reliés aux régions siliciurées 122 et aux grilles 128.

Comme pour le premier procédé, ce troisième procédé peut s'appliquer pour réaliser un dispositif 100 comportant plusieurs JoFETs 102 reliés électriquement en série par les deuxièmes régions 114 qui sont communes à deux JoFETs 102 voisins.

En variante, ce troisième procédé pourrait être mis en oeuvre à partir d'un substrat de type semi-conducteur sur isolant tel que celui utilisé dans le deuxième procédé précédemment décrit, en appliquant éventuellement les différentes variantes de mise en œuvre précédemment décrites pour le deuxième procédé.

Quel que soit le procédé mis en oeuvre, le dispositif 100 obtenu est co-intégrable, sur un même substrat, avec d'autres types de dispositifs du domaine des semi-conducteurs.

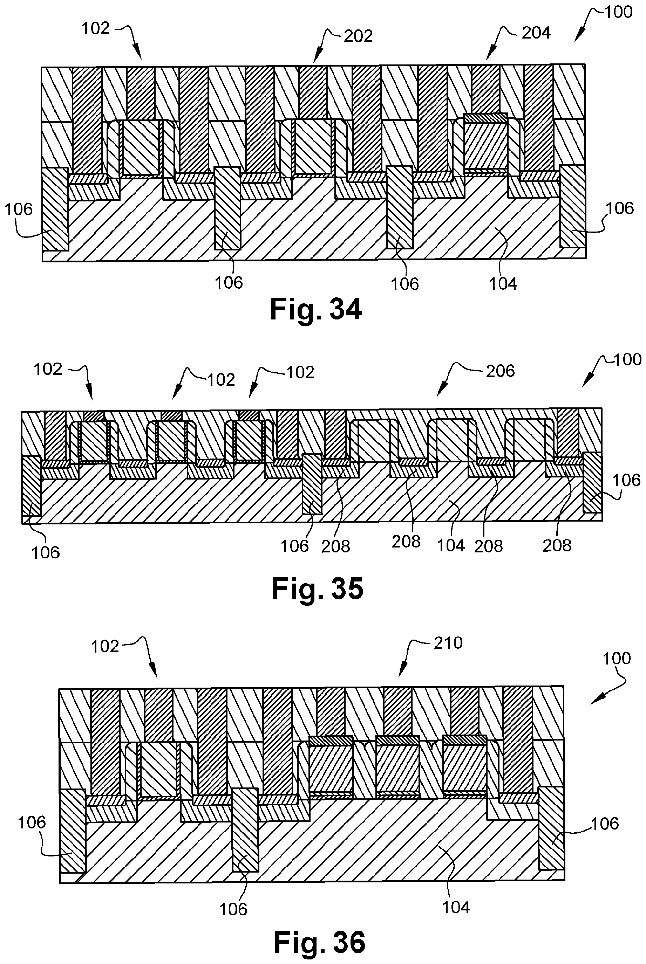

Par exemple, la figure 34 représente un dispositif 100 comprenant un ou plusieurs qubits supraconducteurs incluant au moins un JoFET 102 (un seul JoFET 102 est visible sur la figure 34) réalisé dans le substrat semi-conducteur 104, et comprenant également des dispositifs de type CMOS, c'est-à-dire des transistors de type FET. Sur la figure 34, un transistor 202 de type « Gate Last », c'est-à-dire dont la grille a été réalisée après la réalisation des espaceurs latéraux et le retrait d'une grille temporaire, et un transistor 204 de type « Gate First », c'est-à-dire dont la grille a été réalisée par des dépôts de couches préalablement au reste du transistor, réalisés dans le substrat 104 sont visibles.

Selon un autre exemple, la figure 35 représente un dispositif 100 comprenant un ou plusieurs qubits supraconducteurs incluant plusieurs JoFETs 102 couplés électriquement en série par des deuxièmes régions 114 communes à deux des JoFETs 102 et réalisés dans le substrat semi-conducteur 104, et comprenant également une chaîne d'Andreev 206 réalisée à partir de régions supraconductrices 208 par exemple obtenues par la mise en oeuvre des étapes réalisant les deuxièmes régions 114 des JoFETs 102.

Selon un autre exemple, la figure 36 représente un dispositif 100 comprenant un ou plusieurs qubits supraconducteurs incluant au moins un JoFET 102 (un seul JoFET 102 est visible sur la figure 36) réalisé dans le substrat semi-conducteur 104, et comprenant également des dispositifs 210 à qubits de spin.

## Revendications

1. Procédé de réalisation d'un dispositif électronique (100) à qubit(s) supraconducteur(s) incluant au moins un transistor à effet de champ à jonction Josephson, JoFET, (102) formé par la mise en oeuvre des étapes de :
- réalisation, sur au moins une couche de semi-conducteur (104, 138), d'au moins une portion diélectrique de protection (110) disposée sur au moins une première région (112) de la couche de semi-conducteur (104, 138) ;
- implantation de dopants dans des deuxièmes régions (114) de la couche de semi-conducteur (104, 138), adjacentes à la première région (112) et telles que la première région (112) soit disposée entre les deuxièmes régions (114) ;
- dépôt d'une couche diélectrique de protection (116) recouvrant au moins la portion diélectrique de protection (110) et les deuxièmes régions (114) ;
- exposition de la couche diélectrique de protection (116) à au moins une impulsion laser;
- retrait d'au moins une partie de la couche diélectrique de protection (116) recouvrant les deuxièmes régions (114) ;
- retrait de la portion diélectrique de protection (110) ;
- réalisation d'au moins une grille de contrôle électrostatique (128) sur la première région (112) ;
et dans lequel les matériaux et les épaisseurs de la portion diélectrique de protection (110) et de la couche diélectrique de protection (116), ainsi que la durée et la puissance de ladite au moins une impulsion laser, sont choisis tels que la superposition de la portion diélectrique de protection (110) et de la couche diélectrique de protection (116) sur la première région (112) empêche ladite au moins une impulsion laser d'atteindre la première région (112), et que la présence de la couche diélectrique de protection (116) seule sur les deuxièmes régions (114) permette à ladite au moins une impulsion laser d'atteindre les deuxièmes régions (114) et de fondre le semi-conducteur des deuxièmes régions (114) qui forme, après un refroidissement, un matériau semi-conducteur recristallisé possédant des propriétés de matériau supraconducteur.

2. Procédé selon la revendication 1, dans lequel la portion diélectrique de protection (110) comporte du SiN, et dans lequel la couche diélectrique de protection (116) comporte du SiN et/ou du SiCO et/ou du SiO₂.

3. Procédé selon l'une des revendications précédentes, dans lequel le choix des matériaux et des épaisseurs de la portion diélectrique de protection (110) et de la couche diélectrique de protection (116) est réalisé :
- en choisissant le matériau et l'épaisseur de la couche diélectrique de protection (116) tels que la couche diélectrique de protection (116) présente une réflectivité, vis-à-vis de la longueur d'onde de ladite au moins une impulsion laser, inférieure ou égale à 15 %, puis
- en choisissant le matériau et l'épaisseur de la portion diélectrique de protection (110) tels que la superposition de la portion diélectrique de protection (110) et de la couche diélectrique de protection (116) présente une réflectivité, vis-à-vis de la longueur d'onde de ladite au moins une impulsion laser, supérieure ou égale à 50 %.

4. Procédé selon l'une des revendications précédentes, dans lequel :
- la couche diélectrique de protection (116) est déposée de manière conforme, et
- le retrait d'au moins une partie de la couche diélectrique de protection (116) recouvrant les deuxièmes régions (114) est réalisé en mettant en oeuvre une gravure anisotrope de la couche diélectrique de protection (116) telle que des portions restantes (120) de la couche diélectrique de protection (116) forment des espaceurs diélectriques latéraux disposés contre des flancs latéraux de la portion diélectrique de protection (110).

5. Procédé selon l'une des revendications 1 à 3, comportant en outre, entre la réalisation de la portion diélectrique de protection (110) et l'implantation des dopants dans les deuxièmes régions (114) :
- dépôt conforme d'une deuxième couche diélectrique recouvrant au moins la portion diélectrique de protection (110) et les deuxièmes régions (114) ;
- gravure anisotrope de la deuxième couche diélectrique telle que des portions restantes (140) de la deuxième couche diélectrique recouvrent des flancs latéraux de la portion diélectrique de protection (110) et soient disposées sur la première région (112) ;
- épitaxie de semi-conducteur (142) sur les deuxièmes régions (114) ;
et dans lequel la couche diélectrique de protection (116) déposée recouvre également les portions restantes (140) de la deuxième couche diélectrique.

6. Procédé selon la revendication 5, dans lequel :
- la couche diélectrique de protection (116) est déposée de manière conforme, et le retrait d'au moins une partie de la couche diélectrique de protection (116) recouvrant les deuxièmes régions (114) est réalisée en mettant en oeuvre une gravure anisotrope de la couche diélectrique de protection (116), des portions restantes de la couche diélectrique de protection (116) formant, avec les portions restantes (140) de la deuxième couche diélectrique, des espaceurs diélectriques latéraux disposés contre des flancs latéraux de la portion diélectrique de protection (110), ou
- le retrait d'au moins une partie de la couche diélectrique de protection (116) correspond à un retrait total de la couche diélectrique de protection (116).

7. Procédé selon l'une des revendications 1 à 3, comportant en outre, entre la réalisation de la portion diélectrique de protection (110) et l'implantation des dopants dans les deuxièmes régions (114) :
- dépôt conforme d'une troisième couche diélectrique recouvrant au moins la portion diélectrique de protection (110) et les deuxièmes régions (114), et dont l'épaisseur est égale au moins à celle de la couche diélectrique de protection (116) formée ultérieurement ;
- gravure anisotrope de la troisième couche diélectrique telle que des portions restantes (146) de la troisième couche diélectrique recouvrent des flancs latéraux de la portion diélectrique de protection (110) et soient disposées sur la première région (112) ;
et comportant en outre, entre l'implantation des dopants dans les deuxièmes régions (114) et le dépôt de la couche diélectrique de protection (116), un retrait des portions restantes (146) de la troisième couche diélectrique.

8. Procédé selon la revendication 7, comportant en outre, entre le retrait d'au moins une partie de la couche diélectrique de protection (116) recouvrant les deuxièmes régions (114) et le retrait de la portion diélectrique de protection (110), une réalisation d'espaceurs diélectriques latéraux (148) contre des portions restantes (120) de la couche diélectrique de protection (116), et dans lequel la réalisation de la grille de contrôle électrostatique (128) est précédée d'un retrait des portions restantes (120) de la couche diélectrique de protection (116).

9. Procédé selon l'une des revendications précédentes, dans lequel la couche de semi-conducteur (138) correspond à une couche superficielle d'un substrat de type semi-conducteur sur isolant.

10. Procédé selon la revendication 9, dans lequel les dopants sont implantés dans toute l'épaisseur de la couche de semi-conducteur (138), ou dans lequel les dopants sont implantés dans une partie seulement de l'épaisseur de la couche de semi-conducteur (138).

11. Procédé selon l'une des revendications précédentes, dans lequel les dopants correspondent à des atomes de bore implantés avec une dose comprise entre 1.10¹⁶ et 9.10¹⁷ at/cm².

12. Procédé selon l'une des revendications précédentes, comportant en outre, avant la réalisation de la portion diélectrique de protection (110), la réalisation de tranchées d'isolation (106) à travers au moins une partie de l'épaisseur de la couche de semi-conducteur (104, 138), et dans lequel les étapes ensuite mises en oeuvre forment plusieurs JoFETs (102) isolés électriquement les uns des autres par les tranchées d'isolation (106).

13. Procédé selon l'une des revendications précédentes, dans lequel les étapes mises en oeuvre forment plusieurs JoFETs (102) couplés électriquement en série par l'intermédiaire de deuxièmes régions (114) communes à deux desdits JoFETs (102).

14. Procédé selon l'une des revendications précédentes, comportant en outre la réalisation, dans la couche de semi-conducteur (104, 138), de dispositifs à qubits de spin (210) et/ou de dispositifs de type CMOS (202, 204) et/ou d'au moins une chaîne d'Andreev (206) comportant d'autres régions (208) de semi-conducteur recristallisé possédant des propriétés de matériau supraconducteur.

## Patentansprüche

1. Verfahren zum Herstellen einer supraleitenden elektronischen Qubit-Vorrichtung (100), die mindestens einen Feldeffekttransistor mit Josephson-Übergang, JoFET, enthält und durch das Durchführen der folgenden Schritte gebildet wird:
- Herstellen, über mindestens einer Halbleiterschicht (104, 138), mindestens eines dielektrischen Schutzabschnitts (110), der über mindestens einem ersten Bereich (112) der Halbleiterschicht (104, 138) angeordnet ist;
- Implantieren von Dotierstoffen in zweite Bereiche (114) der Halbleiterschicht (104, 138) angrenzend an den ersten Bereich (112) und derart, dass der erste Bereich (112) zwischen den zweiten Bereichen (114) angeordnet ist;
- Abscheiden einer dielektrischen Schutzschicht (116), die mindestens den dielektrischen Schutzabschnitt (110) und die zweiten Bereiche (114) bedeckt;
- Aussetzen der dielektrischen Schutzschicht (116) mindestens einem Laserimpuls;
- Entfernen mindestens eines Teils der dielektrischen Schutzschicht (116), die die zweiten Bereiche (114) bedeckt;
- Entfernen des dielektrischen Schutzabschnitts (110);
- Herstellen mindestens eines elektrostatischen Steuergates (128) über dem ersten Bereich (112);
und wobei die Materialien und die Dicken des dielektrischen Schutzabschnitts (110) und der dielektrischen Schutzschicht (116) sowie die Dauer und die Leistung des mindestens einen Laserimpulses derart ausgewählt werden, dass die Überlagerung des dielektrischen Schutzabschnitts (110) und der dielektrischen Schutzschicht (116) über dem ersten Bereich (112) verhindert, dass der mindestens eine Laserimpuls den ersten Bereich (112) erreicht, und dass das Vorhandensein der dielektrischen Schutzschicht (116) allein über den zweiten Bereichen (114) es dem mindestens einen Laserimpuls ermöglicht, die zweiten Bereiche (114) zu erreichen und den Halbleiter der zweiten Bereiche (114) zu schmelzen, der nach dem Abkühlen ein rekristallisiertes Halbleitermaterial bildet, das supraleitende Materialeigenschaften besitzt.

2. Verfahren nach Anspruch 1, wobei der dielektrische Schutzabschnitt (110) SiN umfasst, und wobei die dielektrische Schutzschicht (116) SiN und/oder SiCO und/oder SiO₂ umfasst.

3. Verfahren nach einem der vorhergehenden Ansprüche, wobei die Auswahl der Materialien und der Dicken des dielektrischen Schutzabschnitts (110) und der dielektrischen Schutzschicht (116) wie folgt ausgeführt wird:
- durch das Auswählen des Materials und der Dicke der dielektrischen Schutzschicht (116), so dass die dielektrische Schutzschicht (116) für die Wellenlänge des mindestens einen Laserimpulses ein Reflexionsvermögen von weniger als oder gleich 15 % aufweist, dann
- durch das Auswählen des Materials und der Dicke des dielektrischen Schutzabschnitts (110), so dass die Überlagerung des dielektrischen Schutzabschnitts (110) und der dielektrischen Schutzschicht (116) für die Wellenlänge des mindestens einen Laserimpulses ein Reflexionsvermögen von mehr als oder gleich 50 % aufweist.

4. Verfahren nach einem der vorhergehenden Ansprüche, wobei:
- die dielektrische Schutzschicht (116) konform abgeschieden wird, und
- das Entfernen mindestens eines Teils der dielektrischen Schutzschicht (116), die die zweiten Bereiche (114) bedeckt, durch das Durchführen eines anisotropen Ätzens der dielektrischen Schutzschicht (116) ausgeführt wird, so dass verbleibende Abschnitte (120) der dielektrischen Schutzschicht (116) seitliche dielektrische Abstandshalter bilden, die an Seitenwänden des dielektrischen Schutzabschnitts (110) angeordnet sind.

5. Verfahren nach einem der Ansprüche 1 bis 3, das ferner zwischen dem Herstellen des dielektrischen Schutzabschnitts (110) und dem Implantieren der Dotierstoffe in den zweiten Bereichen (114) Folgendes umfasst:
- konformes Abscheiden einer zweiten dielektrischen Schicht, die mindestens den dielektrischen Schutzabschnitt (110) und die zweiten Bereiche (114) bedeckt;
- anisotropes Ätzen der zweiten dielektrischen Schicht, so dass verbleibende Abschnitte (140) der zweiten dielektrischen Schicht Seitenwände des dielektrischen Schutzabschnitts (110) bedecken und über dem ersten Bereich (112) angeordnet werden;
- eine Halbleiterepitaxie (142) über den zweiten Bereichen (114);
und wobei die abgeschiedene dielektrische Schutzschicht (116) auch die verbleibenden Abschnitte (140) der zweiten dielektrischen Schicht bedeckt.

6. Verfahren nach Anspruch 5, wobei:
- die dielektrische Schutzschicht (116) konform abgeschieden wird, und das Entfernen mindestens eines Teils der dielektrischen Schutzschicht (116), die die zweiten Bereiche (114) bedeckt, ausgeführt wird, indem ein anisotropes Ätzen der dielektrischen Schutzschicht (116) durchgeführt wird, wobei verbleibende Abschnitte der dielektrischen Schutzschicht (116) mit den verbleibenden Abschnitten (140) der zweiten dielektrischen Schicht seitliche dielektrische Abstandshalter bilden, die an Seitenwänden des dielektrischen Schutzabschnitts (110) angeordnet sind, oder
- das Entfernen mindestens eines Teils der dielektrischen Schutzschicht (116) einem vollständigen Entfernen der dielektrischen Schutzschicht (116) entspricht.

7. Verfahren nach einem der Ansprüche 1 bis 3, das ferner zwischen dem Herstellen des dielektrischen Schutzabschnitts (110) und dem Implantieren der Dotierstoffe in den zweiten Bereichen (114) Folgendes umfasst:
- konformes Abscheiden einer dritten dielektrischen Schicht, die mindestens den dielektrischen Schutzabschnitt (110) und die zweiten Bereiche (114) bedeckt und deren Dicke mindestens gleich der der anschließend gebildeten dielektrischen Schutzschicht (116) ist;
- anisotropes Ätzen der dritten dielektrischen Schicht, so dass verbleibende Abschnitte (146) der dritten dielektrischen Schicht die Seitenwände des dielektrischen Schutzabschnitts (110) bedecken und über dem ersten Bereich (112) angeordnet werden;
und ferner zwischen dem Implantieren der Dotierstoffe in den zweiten Bereichen (114) und dem Abscheiden der dielektrischen Schutzschicht (116) ein Entfernen der verbleibenden Abschnitte (146) der dritten dielektrischen Schicht umfasst.

8. Verfahren nach Anspruch 7, das ferner zwischen dem Entfernen mindestens eines Teils der dielektrischen Schutzschicht (116), die die zweiten Bereiche (114) bedeckt, und dem Entfernen des dielektrischen Schutzabschnitts (110) ein Herstellen von seitlichen dielektrischen Abstandshaltern (148) an verbleibenden Abschnitten (120) der dielektrischen Schutzschicht (116) umfasst, und wobei dem Herstellen des elektrostatischen Steuergates (128) ein Entfernen der verbleibenden Abschnitte (120) der dielektrischen Schutzschicht (116) vorausgeht.

9. Verfahren nach einem der vorhergehenden Ansprüche, wobei die Halbleiterschicht (138) einer Oberflächenschicht eines Substrats vom Halbleiterauf-Isolator-Typ entspricht.

10. Verfahren nach Anspruch 9, wobei die Dotierstoffe über die gesamte Dicke der Halbleiterschicht (138) implantiert werden, oder wobei die Dotierstoffe nur über einen Teil der Dicke der Halbleiterschicht (138) implantiert werden.

11. Verfahren nach einem der vorhergehenden Ansprüche, wobei die Dotierstoffe Boratomen entsprechen, die in einer Menge zwischen 1×10¹⁶ und 9×10¹⁷ at/cm² implantiert werden.

12. Verfahren nach einem der vorhergehenden Ansprüche, das ferner vor dem Herstellen des dielektrischen Schutzabschnitts (110) das Herstellen von Isolationsgräben (106) durch mindestens einen Teil der Dicke der Halbleiterschicht (104, 138) umfasst, und wobei die anschließend durchgeführten Schritte mehrere JoFETs (102) bilden, die durch die Isolationsgräben (106) voneinander elektrisch isoliert sind.

13. Verfahren nach einem der vorhergehenden Ansprüche, wobei die durchgeführten Schritte mehrere JoFETs (102) bilden, die über zweite Bereiche (114), die zwei der JoFETs (102) gemeinsam sind, elektrisch in Reihe gekoppelt sind.

14. Verfahren nach einem der vorhergehenden Ansprüche, das ferner das Herstellen von Spin-Qubit-Vorrichtungen (210) und/oder von Vorrichtungen vom CMOS-Typ (202, 204) und/oder mindestens einer Andreev-Kette (206) in der Halbleiterschicht (104, 138) mit weiteren rekristallisierten Halbleiterbereichen (208), die supraleitende Materialeigenschaften besitzen, umfasst.

## Claims

1. A method for fabricating out an electronic device (100) with superconductor qubit(s) including at least one JoFET (102) formed by the implementation of the steps of:
- making, over at least one semiconductor layer (104, 138), at least one protective dielectric portion (110) arranged over at least one first region (112) of the semiconductor layer (104, 138);
- implanting dopants in second regions (114) of the semiconductor layer (104, 138), adjacent to the first region (112) and such that the first region (112) is arranged between the second regions (114) ;
- depositing a protective dielectric layer (116) covering at least the protective dielectric portion (110) and the second regions (114) ;
- exposing the protective dielectric layer (116) to at least one laser pulse;
- removing at least one portion of the protective dielectric layer (116) covering the second regions (114);
- removing the protective dielectric portion (110);
- making at least one electrostatic control gate (128) over the first region (112);
and wherein the materials and the thicknesses of the protective dielectric portion (110) and of the protective dielectric layer (116), as well as the duration and the power of said at least one laser pulse, are selected such that the superposition of the protective dielectric portion (110) and of the protective dielectric layer (116) over the first region (112) prevents said at least one laser pulse from reaching the first region, and that the presence of the protective dielectric layer (116) alone over the second regions (114) enables said at least one laser pulse to reach the second regions (114) and melt the semiconductor of the second regions which forms, after cooling, a recrystallised semiconductor material having superconductor material properties.

2. The method according to claim 1, wherein the protective dielectric portion (110) includes SiN, and wherein the protective dielectric layer (116) includes at least one of: SiN, SiCo, SiO₂.

3. The method according to any of the preceding claims, wherein the selection of the materials and of the thicknesses of the protective dielectric portion (110) and of the protective dielectric layer (116) is carried out:
- by selecting the material and the thickness of the protective dielectric layer (116) such that the protective dielectric layer (116) has a reflectivity, for the wavelength of said at least one laser pulse, lower than or equal to 15%, then
- by selecting the material and the thickness of the protective dielectric portion (110) such that the superposition of the protective dielectric portion (110) and of the protective dielectric layer (116) has a reflectivity, for the wavelength of said at least one laser pulse, higher than or equal to 50%.

4. The method according to the preceding claims, wherein:
- the protective dielectric layer (116) is conformally deposited, and
- the removal of at least one portion (116) of the protective dielectric layer covering the second regions (114) is carried out by implementing an anisotropic etching of the protective dielectric layer such that remaining portions (120) of the protective dielectric layer (116) form lateral dielectric spacers arranged against sidewalls of the protective dielectric portions (110).

5. The method according to any of the claims 1 to 3, further including, between the making of the protective dielectric portion (110) and the implantation of the dopants in the second regions:
- conformal deposition of a second dielectric layer covering at least the protective dielectric portion and the second regions (114);
- anisotropic etching of the second dielectric layer such that remaining portions (140) of the second dielectric layer cover sidewalls of the protective dielectric portion (110) and are arranged over the first region (112) ;
- a semiconductor epitaxy (142) over the second regions;
and wherein the deposited protective dielectric layer also covers the remaining portions (140) of the second dielectric layer.

6. The method according to claim 5, wherein:
- the protective dielectric layer (116) is conformally deposited, and the removal of at least one portion of the protective dielectric layer (116) covering the second regions (114) is carried out by implementing an anisotropic etching of the protective dielectric layer (116), remaining portions (140) of the protective dielectric layer forming, with the remaining portions of the second dielectric layer, lateral dielectric spacers arranged against sidewalls of the protective dielectric portion (110), or
- the removal of at least one portion of the protective dielectric layer (116) corresponds to a total removal of the protective dielectric layer (116).

7. The method according to any of the claims 1 to 3, further including, between the making of the protective dielectric portion (110) and the implantation of the dopants in the second regions (114):
- conformal deposition of a third dielectric layer covering at least the protective dielectric portion (110) and the second regions (114), and whose thickness is equal at least to that of the protective dielectric layer (116) formed subsequently;
- anisotropic etching of the third dielectric layer such that remaining portions (146) of the third dielectric layer cover sidewalls of the protective dielectric portion and are arranged over the first region (112);
and further including, between the implantation of the dopants in the second regions (114) and the deposition of the protective dielectric layer (116), a removal of the remaining portions (146) of the third dielectric layer.

8. The method according to claim 7, further including, between the removal of at least one portion of the protective dielectric layer (116) covering the second regions (114) and the removal of the protective dielectric portion (110), making of lateral dielectric spacers (148) against remaining portions (120) of the protective dielectric layer (116), and wherein the making of the electrostatic control gate (128) is preceded by a removal of the remaining portions (120) of the protective dielectric layer (116).

9. The method according to any of the preceding claims, wherein the semiconductor layer (138) corresponds to a superficial layer of a semiconductor-on-insulator type substrate.

10. The method according to claim 9, wherein the dopants are implanted within all the thickness of the semiconductor layer (138), or wherein the dopants are implanted within only one portion of the thickness of the semiconductor layer (138).

11. The method according to any of the preceding claims, wherein the dopants correspond to boron atoms implanted with a dose between 1.10¹⁶ and 9.10¹⁷ at/cm².

12. The method according to any of the preceding claims, further including, before the making of the protective dielectric portion (110), the making of isolation trenches (106) through at least one portion of the thickness of the semiconductor layer (104, 138), and wherein the steps implemented afterwards form several JoFETs (102) electrically isolated from each other by the isolation trenches (106).

13. The method according to any of the preceding claims, wherein the implemented steps form several JoFETs (102) electrically coupled in series via second regions (114) common to two of said JoFETs (102).

14. The method according to any of the preceding claims, further including the making, in the semiconductor layer (104, 138), of devices with spin qubits (210) and/or CMOS-type devices (202, 204) and/or at least one Andreev chain (206) including other regions (208) of a recrystallised semiconductor having superconductor material properties.
